# EUROPEAN PATENT SPECIFICATION

(11) **EP 3 138 933 B1**
(45) Date of publication and mention of the grant of the patent: **29.04.2020**
(21) Application number: 15785599.0
(22) Date of filing: 30.04.2015
(51) Int. Cl.: C22C 21/02, C22C 21/04, C22F 1/043, B22D 17/00, H01L 23/373, C22F 1/00

(54) **METHOD FOR MANUFACTURING HEAT RADIATOR FINS COMPRISING ALUMINUM ALLOY**
VERFAHREN ZUR HERSTELLUNG VON KÜHLKÖRPERRIPPEN AUS EINER ALUMINIUMLEGIERUNG
PROCÉDÉ DE FABRICATION D'AILETTES DE RADIATEUR EN ALLIAGE D'ALUMINIUM

(30) Priority: 02.05.2014 JP 2014095110
(43) Date of publication of application: 08.03.2017
(73) Proprietor: Asanuma Giken Co., Ltd., Hamamatsu-shi, Shizuoka 431-1103 (JP)
(72) Inventor: SUGIURA, Yasuo, Hamamatsu-shi Shizuoka 431-1103 (JP); KAMIKUBO, Yoshinori, Hamamatsu-shi Shizuoka 431-1103 (JP); TAKAHASHI, Masashi, Hamamatsu-shi Shizuoka 431-1103 (JP); YAMAMOTO, Kensuke, Hamamatsu-shi Shizuoka 431-1103 (JP)
(74) Representative: Cohausz & Florack
(86) International application number: PCT/JP2015/063000
(87) International publication number: WO 2015/166992

(56) References cited:
- EP-A2- 2 574 411
- WO-A1-2011/158477
- JP-A- 2005 272 966
- JP-A- 2006 037 190
- JP-A- 2006 063 420
- US-A1- 2005 103 461
- MAO W M ET AL: "Rheo-squeeze casting of semi-solid A356 aluminum alloy slurry", TRANSACTIONS OF NONFERROUS METALS SOCIETY OF CHINA : ENGLISH EDITION = ZHONGGUO-YOUSE-JINSHU-XUEBAO, ELSEVIER, AMSTERDAM, NL, vol. 20, no. 9, 1 September 2010 (2010-09-01), pages 1769-1773, XP027556741, ISSN: 1003-6326 [retrieved on 2010-09-01]

## Description

### Technical Field

The present invention relates to a method for producing a radiating fin formed of an aluminum alloy, which has high thermal conductivity and high strength.

### Background Art

In next-generation vehicles such as hybrid vehicles and electric vehicles, the heat generation density increases with increasing the output of and decreasing the size of storage batteries and power devices, and measures need to be taken against radiation of the generated heat. In addition to such next-generation vehicles, the same problem arises in transporters such as airplanes, LED luminaires, personal computers, household electric appliances such as refrigerators, and any other devices that require electric power.

Because of such recent circumstances, the improvement in heat radiation performance of heat sinks and the like is regarded as important. In general, copper or aluminum is used as a metal heat radiation material for heat sinks, and extrusion or forging is employed as a production method. However, the improvement in performance by elaborating the fin portions of heat sinks, which has been carried out so far, has substantially reached its limit from the viewpoint of, for example, workability and thermal resistance. Furthermore, extrusion and forging have a low degree of freedom in shape because of problems attributable to their production methods and also require high cost, which makes it difficult to employ extrusion and forging.

Accordingly, various materials that are used for fins of heat sinks and that has high thermal conductivity and thus produces an excellent heat-radiating effect have been proposed. For example, as disclosed in PTL 1, an aluminum alloy having high strength and high thermal conductivity and obtained by casting a material containing silicon (Si), magnesium (Mg), iron (Fe), and boron (B) as additives, with the balance being aluminum (Al) and unavoidable impurities, by die casting and then performing aging heat treatment is proposed.

### Citation List

### Patent Literature

PTL 1: Japanese Unexamined Patent Application Publication No. 2006-63420
US 2005/0103461 A1, which discloses injection molding of semi solid aluminium alloy.

### Summary of Invention

### Technical Problem

In the above related art, however, a die casting method is required, which poses a problem in that the thermal conductivity cannot be sufficiently improved. That is, a die casting method is a production method in which molten metal is injected into a mold at high speed and high pressure. Therefore, inclusion of air and oxides often occurs and many minute defects called microporosity are formed, which causes a decrease in the thermal conductivity. Thus, the actual thermal conductivity of die-cast products is much lower than the nominal value. Furthermore, the addition of metal elements such as iron (Fe) is required to prevent seizure of aluminum onto a die. However, if an alloy is formed while metal elements such as iron (Fe) are contained in aluminum, the thermal conductivity decreases in proportion to the amounts of alloy components. If the amounts of alloy components are decreased in a die casting method, the castability degrades, which increases the fraction defective and decreases the yield.

In view of the foregoing, it is an object of the present invention to provide a method for producing the radiating fin formed of an aluminum alloy which does not require addition of metal elements such as iron, which has high formability, and with which high thermal conductivity can be achieved.

### Solution to Problem

A radiating fin is formed of an aluminum alloy obtained by injecting a semi-solid material into a mold at a speed of 0.15 to 0.4 (m/s) and a pressure of 15 to 30 (MPa) to perform semi-solid forming and then performing heat treatment at 190°C to 290°C for 1 to 5 hours, wherein the semi-solid material has a chemical composition containing 2 to 6 wt% of silicon (Si) and 0.7 wt% or less of magnesium (Mg), with the balance being aluminum (Al) and unavoidable impurities, contains only silicon (Si) and magnesium (Mg) as additives, and has a granular crystalline structure.

In the invention according to Claim 1, a method for producing a radiating fin formed of an aluminum alloy includes injecting a semi-solid material into a mold at a speed of 0.15 to 0.4 (m/s) and a pressure of 15 to 30 (MPa) to perform semi-solid forming and then performing heat treatment at 190°C to 290°C for 1 to 5 hours, wherein the semi-solid material has a chemical composition containing 2 to 6 wt% of silicon (Si) and 0.7 wt% or less of magnesium (Mg), with the balance being aluminum (Al) and unavoidable impurities, contains only silicon (Si) and magnesium (Mg) as additives, and has a granular crystalline structure. Advantageous Effects of Invention

In the invention according to Claim 1, a semi-solid material having a granular crystalline structure is used. Therefore, good fluidity can be achieved when the material is injected into a mold during forming. Even if the material is injected into the mold at low temperature, low speed, and low pressure, the mold can be satisfactorily filled with the material. This eliminates the need for adding metal elements such as iron and provides high thermal conductivity. As a result, strength and thermal conductivity do not decrease unlike actual die-cast products.

Furthermore, since the semi-solid material is subjected to semi-solid forming and then heat-treated at 190°C to 290°C for 1 to 5 hours, the thermal conductivity can be further improved without adding metal elements such as iron.

### Brief Description of Drawings

[Fig. 1] Fig. 1 is a flowchart illustrating a production process of an aluminum alloy according to an embodiment of the present invention.
[Fig. 2] Fig. 2 is a graph illustrating thermal conductivity plotted against silicon (Si) content in Examples and Comparative Examples of the present invention.
[Fig. 3] Fig. 3 is a graph illustrating thermal conductivity and hardness plotted against annealing temperature in Examples and Comparative Examples of present invention.

### Description of Embodiments

Hereafter, embodiments of the present invention will be specifically described with reference to the attached drawings.

An aluminum alloy according to this embodiment is obtained from a semi-solid material that has a chemical composition containing 2 to 6 wt% of silicon (Si) and 0.7 wt% or less of magnesium (Mg), with the balance being aluminum (Al) and unavoidable impurities, and that has a granular crystalline structure for improving the formability. The aluminum alloy has a thermal conductivity of 180 W(m·K) or more.

Specifically, the aluminum alloy is obtained by performing semi-solid forming on a semi-solid material that has a chemical composition containing 2 to 6 wt% of silicon (Si) and 0.7 wt% or less of magnesium (Mg), with the balance being aluminum (Al) and unavoidable impurities, and that has a granular crystalline structure and then performing heat treatment at 190°C to 290°C for 1 to 5 hours. The semi-solid material is a material that contains only silicon (Si) and magnesium (Mg) as additives and that does not contain iron (Fe) at all. From the viewpoint of the practical reason for cost or the like or the requirement of strength or the like, however, the semi-solid material may be a material that does not contain magnesium (Mg) or a material that contains iron (Fe) as an unavoidable impurity as long as the thermal conductivity does not decrease.

That is, pure aluminum has the highest thermal conductivity, and the thermal conductivity of aluminum decreases proportionately as the amounts of elements added increase. However, pure aluminum has low strength and does not have a solid-liquid coexisting region for semi-solid forming, and thus it is impossible to perform semi-solid forming. Therefore, in order to improve the thermal conductivity while achieving high strength, the amounts of elements added need to be decreased as much as possible on condition that semi-solid forming can be performed.

Accordingly, the additive (element) added to pure aluminum in this embodiment is at least only silicon (Si). When magnesium (Mg) is added, the amount of magnesium added is 0.7 wt% or less. Addition of magnesium (Mg) is not necessarily required, but the addition of magnesium (Mg) can improve the strength of a formed article. Silicon (Si) is required to provide a solid-liquid coexisting state during heating, which allows semi-solid forming, thereby improving the fluidity (fluidity of molten metal for a mold). Magnesium (Mg) is required to improve the strength of a formed article. There is no need for adding iron (Fe) which has been required for conventional die casting alloys. The reason for this is as follows. Iron (Fe) added to die casting alloys is required to prevent seizure of aluminum onto a die. However, when semi-solid forming is employed as in this embodiment, there is no need for adding iron (Fe) because the casting temperature is about 100°C lower than that in a die casting method, and thus a semi-solid material can be injected at low speed and low pressure.

The semi-solid material includes both a material obtained by melting metal to a solid-liquid coexisting state (thixocasting) and a material obtained by cooling molten metal to a solid-liquid coexisting state (rheocasting). In the present invention, the semi-solid material includes both forms (semi-solid). In such a forming method that uses a semi-solid material (semi-solid forming method), the cooling rate during forming is high and fine-grained crystals are formed, and therefore a high-strength formed article is produced, which improves the mechanical properties. Furthermore, a uniform structure is formed at low pressure, and therefore formation of shrinkage holes and segregation hardly occur and a high-quality formed article whose actual strength does not decrease can be provided.

The semi-solid material according to this embodiment is obtained by, for example, a method for mechanically or electromagnetically stirring molten metal, a method for performing granulation during recrystallization by imparting strains, or a method using solidification control. The semi-solid material includes a granular primary crystal. When the semi-solid material is formed, forming is caused from a solid-liquid coexisting region, which increases the cooling rate and thus improves the mechanical properties of products. Furthermore, since the semi-solid material includes a granular primary crystal, such a semi-solid material has better fluidity than molten metal. Even if the semi-solid material is injected at low speed and low pressure, a mold can be satisfactorily filled with the semi-solid material. That is, by using a semi-solid material with good fluidity, formed articles having a complicated shape and thin-walled formed articles can be produced with high precision.

The semi-solid forming may be performed using any material having a semi-solid state. Therefore, a variety of materials can be used, such as a material having high thermal conductivity. The semi-solid forming method is characterized in that heat treatment can be performed and low microporosity is achieved, and thus the thermal conductivity can be further improved. Accordingly, by injecting the semi-solid material into a mold at low speed and low pressure, an aluminum alloy can be satisfactorily produced in the mold.

In the aluminum alloy according to this invention, the thermal conductivity and strength are improved by performing heat treatment after the semi-solid forming. The heat treatment temperature is 190°C to 290°C and the heat treatment time is 1 to 5 hours. As a result of this heat treatment, the solubility of silicon (Si) in a primary α-Al phase decreases, which increases the concentration of aluminum (Al) and thus improves the thermal conductivity. A heat treatment temperature of lower than 190°C or a heat treatment time of less than 1 hour causes insufficient heat treatment, and thus high strength is not achieved. A heat treatment temperature of higher than 290°C causes overaging, which decreases the strength. A heat treatment time of more than 5 hours decreases the strength and degrades the productivity.

To improve the thermal conductivity, the amounts of components other than silicon (Si) and magnesium (Mg) need to be decreased as much as possible. However, this increases the cost. Therefore, the inclusion of impurities (unavoidable impurities) is permissible, for example, as long as the thermal conductivity is not less than 180 W/(m·K). Examples of the unavoidable impurities include copper (Cu), zinc (Zn), iron (Fe), manganese (Mn), nickel (Ni), titanium (Ti), lead (Pb), tin (Sn), and chromium (Cr). However, if a secondary ingot is used for semi-solid materials, it is difficult to decrease the content of iron (Fe), and thus 0.3% or less of iron (Fe) may be contained. Manganese (Mn) and titanium (Ti) considerably decrease the thermal conductivity, and thus 0.05% or less of manganese (Mn) or titanium (Ti) may be contained. Other elements may each be contained in an amount of 0.1% or less.

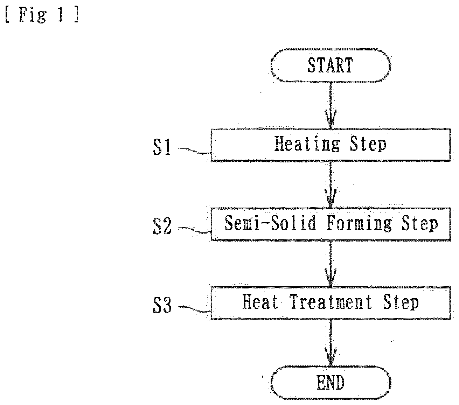

Next, a production process of an aluminum alloy according to this embodiment will be described with reference to a flowchart in Fig. 1.

The aluminum alloy according to this embodiment is obtained through a heating step S1, a semi-solid forming step S2, and a heat treatment step S3 conducted in sequence. The heating step S1 is a step of heating an alloy under particular conditions, prepared by adding silicon (Si) and magnesium (Mg) to aluminum to obtain a semi-solid material which has a granular crystalline structure and has a chemical composition containing 2 to 6 wt% of silicon (Si) and 0.7 wt% or less (preferably 0.2 to 0.7 wt%) of magnesium (Mg), with the balance being aluminum (Al) and unavoidable impurities.

The semi-solid forming step S2 is a step of performing semi-solid forming on the semi-solid material obtained in the heating step S1. The semi-solid material is injected into a desired mold at low speed and low pressure (injected into a mold at a speed of 0.15 to 0.4 (m/s) and a pressure of 15 to 30 (MPa)). The heat treatment step S3 is a step of performing heat treatment on the formed article obtained in the semi-solid forming step S2 at 190°C to 290°C for 1 to 5 hours.

Next, the technical advantages of the present invention will be described based on Examples and Comparative Examples.

An aluminum alloy having a composition listed in Table 1 below was heated and then teemed into a particular container. Solidification control was performed so that a granular primary α-Al phase was obtained, thereby producing a billet. The produced billet was reheated to a semi-solid state and subjected to pressure forming (semi-solid forming) into a disc shape. Formed articles to which 0.5% of magnesium (Mg) was added during dissolution and formed articles to which magnesium (Mg) was not added were produced.

**[Table 1]**

| Name of alloy | Cu | Si | Mg | Zn | Fe | Mn | Ni | Sn | Ti | Pb | Cr | Sr | Al |
|---|---|---|---|---|---|---|---|---|---|---|---|---|---|
| Al-2%Si | 0.000 | 2.183 | 0.002 | 0.007 | 0.138 | 0.003 | 0.003 | 0.001 | 0.005 | 0.0012 | 0.0004 | 0.0003 | Bal. |
| Al-3%Si | 0.000 | 3.104 | 0.002 | 0.007 | 0.128 | 0.003 | 0.002 | 0.001 | 0.006 | 0.0012 | 0.0006 | 0.0003 | Bal. |
| Al-4%Si No.1 | 0.000 | 4.020 | 0.003 | 0.010 | 0.137 | 0.004 | 0.004 | 0.002 | 0.009 | 0.0020 | 0.0010 | 0.0004 | Bal. |
| Al-5%Si | 0.000 | 5.079 | 0.002 | 0.007 | 0.146 | 0.003 | 0.003 | 0.000 | 0.009 | 0.0008 | 0.0010 | 0.0003 | Bal. |
| Al-6%Si | 0.000 | 6.013 | 0.005 | 0.006 | 0.132 | 0.003 | 0.002 | 0.000 | 0.009 | 0.0006 | 0.0012 | 0.0003 | Bal. |
| Al-7%Si | 0.000 | 6.996 | 0.005 | 0.008 | 0.144 | 0.003 | 0.003 | 0.000 | 0.010 | 0.0008 | 0.0014 | 0.0003 | Bal. |
| Al-8%Si | 0.000 | 7.873 | 0.004 | 0.003 | 0.140 | 0.003 | 0.013 | 0.003 | 0.013 | 0.0004 | 0.0015 | 0.0000 | Bal. |

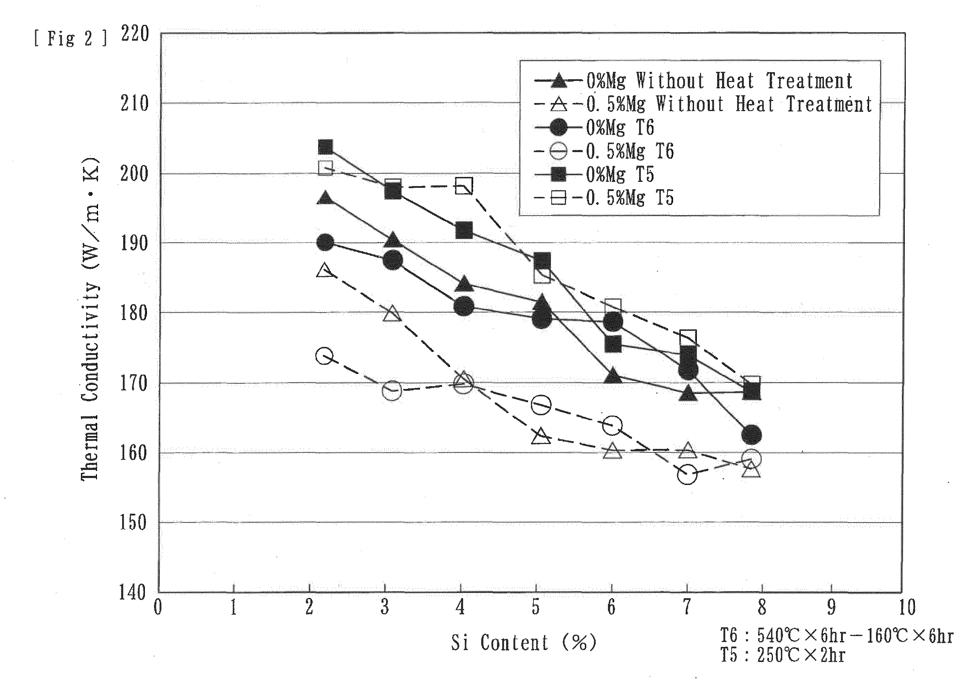

The disc-shaped formed articles were subjected to the following treatments: no heat treatment, heat treatment at 540°C for 6 hours and heat treatment at 160°C for 6 hours (T6), and heat treatment at 250°C for 2 hours (T5). The thermal conductivity (W/(m·K)) and Brinell hardness (HBW) of the resulting formed articles were measured. Table 2 below and Fig. 2 show the results. The formed articles whose silicon (Si) contents were 7% and 8% correspond to Comparative Examples.

**[Table 2]**

| Name of alloy | Heat treatment | 0% Mg | | 0.5% Mg | |
|---|---|---|---|---|---|
| | | Thermal conductivity W/(m·K) | Brinell hardness HBW | Thermal conductivity W/(m·K) | Brinell hardness HBW |
| Al-2%Si | - | 197 | 28 | 186 | 44 |
| | T6 | 190 | 34 | 174 | 104 |
| | T5 | 204 | 29 | 201 | 52 |
| AI-3%Si | - | 190 | 35 | 179 | 47 |
| | T6 | 188 | 35 | 169 | 109 |
| | T5 | 197 | 34 | 198 | 52 |
| Al-4%Si | - | 164 | 37 | 171 | 50 |
| | T6 | 181 | 38 | 170 | 108 |
| | T5 | 192 | 40 | 198 | 51 |
| Al-5%Si | - | 182 | 42 | 162 | 57 |
| | T6 | 179 | 38 | 167 | 110 |
| | T5 | 187 | 43 | 185 | 64 |
| Al-6%Si | - | 171 | 46 | 161 | 61 |
| | T6 | 179 | 38 | 164 | 109 |
| | T5 | 176 | 44 | 181 | 65 |
| Al-7%Si | - | 169 | 47 | 161 | 66 |
| | T6 | 172 | 38 | 157 | 111 |
| | T5 | 174 | 49 | 177 | 66 |
| Al-8%Si | - | 169 | 51 | 158 | 70 |
| | T6 | 1.63 | 41 | 159 | 110 |
| | T5 | 169 | 51 | 170 | 66 |

| | | | | | |
|---|---|---|---|---|---|
| Heat treatment T6: 540°C ×6 hr-160°C × 6 hr T5: 250°C × 2 hr | | | | | |

As is clear from Table 2 above and Fig. 2, the thermal conductivity increases as the silicon (Si) content decreases, and the addition of magnesium (Mg) exhibits a heat treatment effect and thus improves the hardness. That is, in the case where a formed article is obtained through a known die casting method, the melting temperature increases as the silicon (Si) content decreases, and the addition of magnesium (Mg) decreases the fluidity of molten metal. In contrast, in the case where a formed article is obtained through a semi-solid forming method as in the present invention, good fluidity of molten metal is achieved because of a granular primary α-Al phase, and thus forming can be satisfactorily performed.

The heat treatment of T6 (heat treatment at 540°C for 6 hours and heat treatment at 160°C for 6 hours) includes a solution treatment. As is clear from Table 2, the heat treatment of T6 is necessary for improving the strength. However, the formed article is held at high temperatures and then quenched, and therefore impurities in the structure are trapped in aluminum in a dissolved manner, which decreases the thermal conductivity. Accordingly, the heat treatment of T5 (heat treatment at 250°C for 2 hours) (i.e., annealing) is preferably performed.

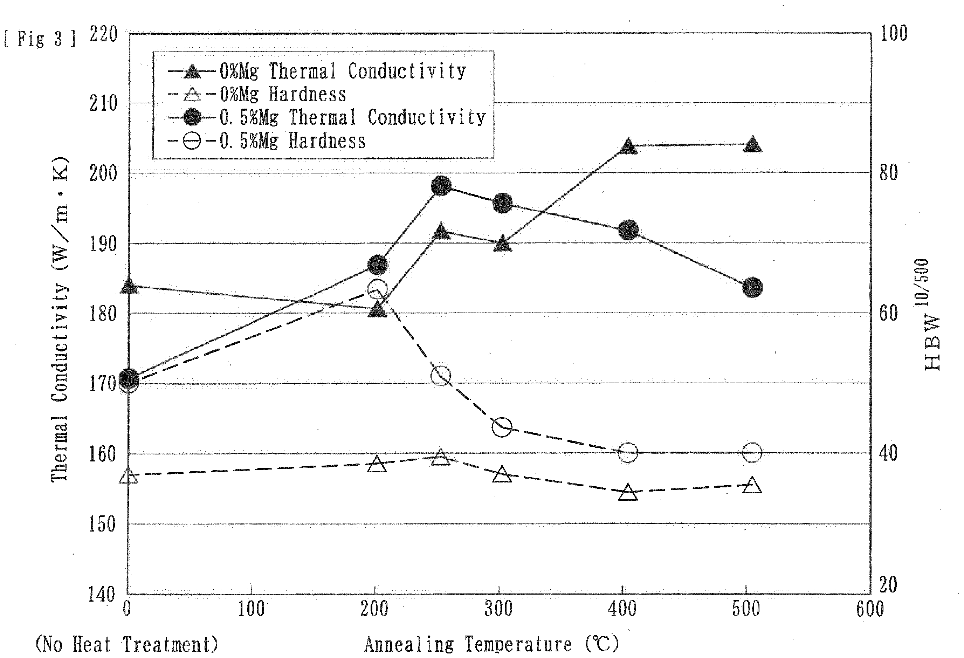

Fig. 3 shows the experimental results of the influence of annealing temperature on thermal conductivity and hardness in the formed article containing 4% of silicon (Si). It is clear from the experimental results that in Example in which the silicon (Si) content is 4% and the magnesium (Mg) content is 0.5%, the annealing temperature is preferably set to 190°C to 290°C to improve the thermal conductivity while achieving a certain degree of hardness.

The embodiments of the present invention have been described so far, but the present invention is not limited thereto. Products obtained through the semi-solid forming are applicable to radiating fins having high thermal conductivity (180 W/(m·K) or more as in this embodiment) and required to produce a good heat-radiating effect.

The invention is defined by the claim.

### Reference Signs List

- S1: heating step
- S2: semi-solid forming step
- S3: heat treatment step

## Claims

1. A method for producing a radiating fin formed of an aluminum alloy, the method comprising injecting a semi-solid material into a mold at a speed of 0.15 to 0.4 (m/s) and a pressure of 15 to 30 (MPa) to perform semi-solid forming and then performing heat treatment at 190°C to 290°C for 1 to 5 hours, wherein the semi-solid material has a chemical composition containing 2 to 6 wt% of silicon (Si) and 0.7 wt% or less of magnesium (Mg), with the balance being aluminum (Al) and unavoidable impurities, contains only silicon (Si) and magnesium (Mg) as additives, and has a granular crystalline structure.

## Patentansprüche

1. Verfahren zur Herstellung einer aus einer Aluminiumlegierung geformten Abstrahlungsrippe, wobei das Verfahren das Einspritzen eines halbfesten Materials in eine Form mit einer Geschwindigkeit von 0,15 bis 0,4 (m/s) und einem Druck von 15 bis 30 (MPa) zur Durchführung einer halbfesten Formgebung und dann die Durchführung einer Wärmebehandlung bei 190°C bis 290°C für 1 bis 5 Stunden umfasst, wobei das halbfeste Material eine chemische Zusammensetzung von 2 bis 6 Gew.-% Silizium (Si) und 0.7 Gew.-% oder weniger Magnesium (Mg) umfasst, wobei der Rest Aluminium (Al) und unvermeidbare Verunreinigungen sind, wobei es nur Silizium (Si) und Magnesium (Mg) als Additive enthält und eine körnige kristalline Struktur hat.

## Revendications

1. Procédé de production d'une ailette radiante formée d'un alliage d'aluminium, le procédé comprenant l'injection d'un matériau semi-solide dans un moule à une vitesse de 0,15 à 0,4 (m/s) et à une pression de 15 à 30 (MPa) pour effectuer un formage semi-solide et puis l'exécution d'un traitement thermique à 190°C à 290°C pendant 1 à 5 heures, dans lequel le matériau semi-solide a une composition chimique contenant 2 à 6 % en poids de silicium (Si) et 0.7 % en poids ou moins de magnésium (Mg), le reste étant de l'aluminium (Al) et des impuretés inévitables, ne contient que du silicium (Si) et du magnésium (Mg) comme additifs, et a une structure cristalline granulaire.
